# EUROPÄISCHE PATENTSCHRIFT

(11) **EP 0 760 023 B1**
(45) Veröffentlichungstag und Bekanntmachung des Hinweises auf die Patenterteilung: **05.11.1997**
(21) Anmeldenummer: 95921737.3
(22) Anmeldetag: 09.05.1995
(51) Int. Cl.: C25D 17/00

(54) **VORRICHTUNG ZUR BEHANDLUNG VON PLATTENFÖRMIGEN WERKSTÜCKEN, INSBESONDERE VON LEITERPLATTEN**
DEVICE FOR PROCESSING FLAT WORKPIECES, IN PARTICULAR PRINTED CIRCUIT BOARDS
DISPOSITIF DE TRAITEMENT DE PIECES PLATES, NOTAMMENT DE CIRCUITS IMPRIMES

(30) Priorität: 11.05.1994 DE 4416708
(43) Veröffentlichungstag der Anmeldung: 05.03.1997
(73) Patentinhaber: Siemens S.A., 1060 Bruxelles (BE)
(72) Erfinder: HOSTEN, Daniel, 8610 Handzame (BE)
(74) Vertreter: Fuchs, Franz-Josef, Dr.-Ing.
(86) Internationale Anmeldenummer: EP9501754
(87) Internationale Veröffentlichungsnummer: WO9531589

(56) Entgegenhaltungen:
- US-A- 4 401 522

## Beschreibung

Aus der EP-A-0 421 127 ist eine Vorrichtung zur Behandlung von Leiterplatten bekannt, bei welcher die einzelnen Leiterplatten in senkrecht hängender Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über an endlos umlaufenden Trieben angeordnete Klammern, die im Falle einer galvanischen Behandlung gleichzeitig auch die kathodische Kontaktierung der Leiterplatten übernehmen. In den Stirnwanden der Behandlungszellen befinden sich vertikale Schlitze für den Durchtritt der Leiterplatten, wobei im Durchtrittsbereich als Bürstendichtungen oder Streifenbürstendichtungen ausgebildete Dichtungen vorgesehen sind. Die einzelnen Behandlungszellen sind in Auffangwannen angeordnet, aus welchen die aufgefangene Badflüssigkeit mit Hilfe entsprechender Pumpen kontinuierlich in die zugeordneten Behandlungszellen zurückgeführt wird. Auch hier wird durch die kontinuierliche Rückführung der Badflüssigkeit die Aufrechterhaltung eines konstanten Pegelstandes in den einzelnen Behandlungszellen ermöglicht.

Aus der US-A-4 401 522 ist eine ähnlich aufgebaute Vorrichtung zur elektrolytischen Behandlung von Leiterplatten bekannt, bei welcher den vertikalen Schlitzen in den Stirnwanden der Behandlungszellen als Dichtungen vertikal angeordnete Walzenpaare zugeordnet sind. Die aus einem elastischen Material bestehenden Walzen dieser Walzenpaare werden federnd gegeneinandergedrückt und mit einer auf die Transportgeschwindigkeit der durchlaufenden Leiterplatten abgestimmten Drehzahl angetrieben.

Der im Anspruch 1 angegebenen Erfindung liegt das Problem zugrunde, bei einer Vorrichtung zur Behandlung von plattenförmigen Werkstücken, die in den Stirnwänden der Behandlungszellen für den Durchtritt der Werkstücke vorgesehenen vertikalen Schlitze mit einfachen Mitteln wirksam abzudichten und den Austritt von Badflüssigkeit im Bereich der Schlitze zu minimieren.

Die mit der Erfindung erzielten Vorteile bestehen insbesondere darin, daß die Abdichtung der Schlitze praktisch selbsttätig durch den Druck der Badflüssigkeit übernommen wird. Durch die lose Anordnung der Stäbe oder Rohre im Behandlungsbad werden sie durch den von der Badflüssigkeit auf sie ausgeübten Druck einerseits gegeneinander oder gegen ein durchlaufendes Werkstück und andererseits von innen gegen die Stirnwand der Behandlungszelle gedrückt, das heißt, der Flüssigkeitsdruck bewirkt eine Abdichtung genau an den Stellen, an denen die Badflüssigkeit austreten könnte. Eine drehbare Lagerung der Stäbe oder Rohre und insbesondere ein Antrieb, wie bei den bekannten, als Dichtungen verwendeten Walzenpaaren, können entfallen.

Vorteilhafte Ausgestaltungen der Erfindung sind in den Unteransprüchen angegeben.

Die Ausgestaltung nach Anspruch 2 ermöglicht ein selbsttätiges Drehen der Stäbe oder Rohre beim Durchlaufen der Werkstücke und damit auch eine Behandlung von Werkstücken, die gegen Reibung äußerst empfindlich sind.

Die Unterbringung der Dichtungen in Schleusenkammern gemäß Anspruch 3, ermöglicht eine gewisse Führung und Halterung der Dichtungen, ohne die für die Dichtwirkung erforderliche lose Anordnung in der Badflüssigkeit zu beeinträchtigen.

Die Ausgestaltung nach Anspruch 4 ermöglicht die Verwendung handelsüblicher Stäbe oder Rohre, die zudem von den meisten Behandlungsbädern nicht angegriffen werden.

Die Weiterbildung nach Anspruch 5 ermöglicht eine selbsttätige Anpassung der Dichtungen an verschiedene Höhen der durchlaufenden Werkstücke. Bei Werkstücken geringerer Höhe werden die unteren Segmente durch den Flüssigkeitsdruck gegeneinander gedrückt, während die oberen Segmente gegen das durchlaufende Werkstück gedrückt werden.

Ein Ausführungsbeispiel der Erfindung ist in der Zeichnung dargestellt und wird im folgenden näher beschrieben.

Es zeigen
- Figur 1: eine Draufsicht auf eine einlaufseitig und auslaufseitig mit Schleusenkammern versehene Behandlungszelle,
- Figur 2: einen Querschnitt der in Figur 1 dargestellten Behandlungszelle,
- Figur 3: eine Schleusenkammer der in Figur 1 dargestellten Behandlungszelle im Detail und
- Figur 4: eine Segmentierung der in den Schleusenkammern angeordneten Dichtungen.

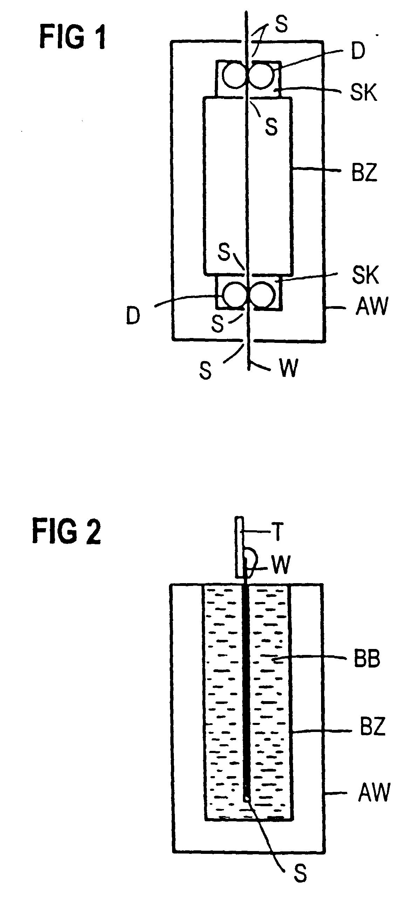

Die Figuren 1 und 2 zeigen in der Draufsicht bzw. im Querschnitt eine in einer Auffangwanne AW angeordnete und ein Behandlungsbad BB enthaltende Behandlungszelle BZ, durch welche an klammerförmigen Transportmitteln T senkrecht hängende, plattenförmige Werkstücke W hindurchgeführt werden. An den beiden Stirnseiten der Behandlungszelle BZ befinden sich Schleusenkammern SK, in welchen durch kreiszylindrische Kunststoffrohre gebildete Dichtungen D paarweise und in vertikaler Ausrichtung lose angeordnet sind. Die Stirnwände der Behandlungszelle BZ,der Schleusenkammern SK und der Auffangwanne AW sind mit vertikalen Schlitzen S versehen, durch welche die plattenförmigen Werkstücke W unbehindert hindurchgeführt werden können.

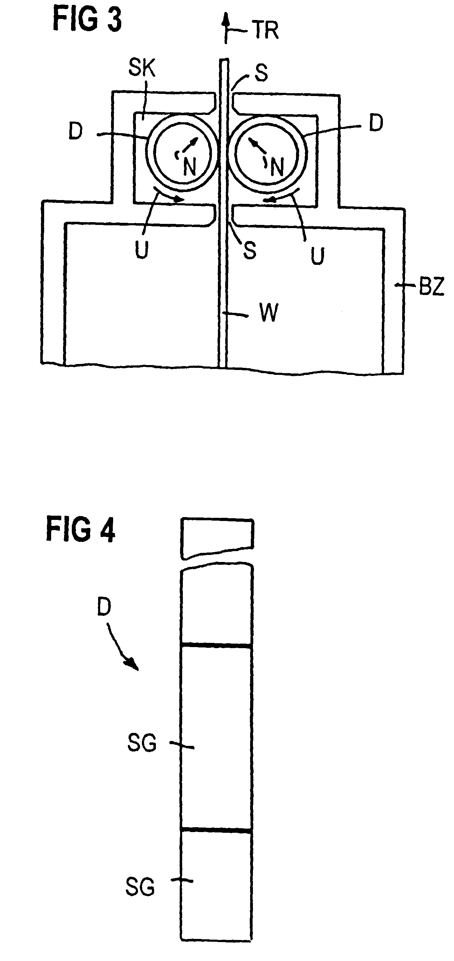

Zur weiteren Erläuterung der Funktionsweise von Schleusenkammer SK und Dichtungen D, wird zusätzlich auf die Figur 3 verwiesen. Der Flüssigkeitsdruck des in der Schleusenkammer SK vorhandenen Behandlungsbades BB, wirkt auf etwa drei Viertel des Umfanges der Dichtungen ein, während auf das restliche Viertel von außen der normale Atmosphärendruck einwirkt. Die resultierenden, auf die Dichtungen D wirkenden Kräfte, sind in Figur 3 durch Pfeile N angedeutet. Es ist ersichtlich, daß diese Kräfte N die Dichtungen D einerseits gegen das durchlaufende Werkstück W und andererseits gegen die Stirnwand der Schleusenkammer SK drücken und damit eine wirkungsvolle Abdichtung bewirken, die den Austritt von Badflüssigkeit zumindest weitgehend verhindert. Befindet sich zwischen den beiden Dichtungen D gerade kein Werkstück W, so werden sie durch die Kräfte N gegeneinander gedrückt und verhindern damit ebenfalls einen Austritt von Badflüssigkeit.

Beim Transport der Werkstücke W durch die Schleusenkammern SK in Transportrichtung TR drehen sich die beiden Dichtungen selbsttätig mit, wobei die Umdrehungungsrichtungen in Figur 3 durch Pfeile U angedeutet sind. Die Reibung zwischen Dichtungen D und Werkstück W ist dabei so gering, daß selbst bei äußerst empfindlichen Werkstücken W keine schädliche Beeinträchtigung zu befürchten ist. In der Behandlungszelle BZ auf das Werkstück W gegebenenfalls aufgebrachte empfindliche Schichten werden ebenfalls nicht beeinträchtigt.

Figur 4 zeigt, daß die Dichtungen D in vertikaler Richtung in Segmente SG unterteilt sind. Hierdurch wird eine selbsttätige Anpassung der Abdichtung an verschiedene Hohen der durchlaufenden Werkstücke W ermöglicht. Beim Durchlauf von Werkstücken W geringerer Höhe werden die oberen Segmente SG gegen das durchlaufende Werkstück W und die unteren Segmente SG gegeneinander gedrückt.

Die vorstehend beschriebene Abdichtung der Behandlungszellen eignet sich insbesondere für die Behandlung von Leiterplatten in galvanischen Bädern und anderen Behandlungsbädern.

Das Prinzip der Abdichtung mittels lose im Behandlungsbad angeordneter Stäbe oder Rohre kann auch bei plattenförmigen Werkstücken eingesetzt werden, die Vorsprünge, Rippen oder andere Erhabenheiten aufweisen, sofern deren Höhe nur geringfügig ist. Diesen vorspringenden Teilen werden dann umlaufende Nuten in den Dichtungen oder Segmente mit entsprechend verringertem Durchmesser zugeordnet.

## Patentansprüche

1. Vorrichtung zur Behandlung von plattenförmigen Werkstücken (W), insbesondere von Leiterplatten, die in vertikaler Lage auf einem horizontalen Transportweg durch mindestens eine, ein Behandlungsbad (BB) enthaltende Behandlunszelle (BZ) geführt werden, wobei in den Stirnwänden der Behandlungszelle (BZ) vertikale Schlitze (S) für den Durchtritt der Werkstücke (W) vorgesehen sind, und wobei den vertikalen Schlitzen (S) Dichtungen (D) zugeordnet sind,
**dadurch gekennzeichnet,**
daß die Dichtungen (D) durch paarweise, in vertikaler Ausrichtung lose im Behandlungsbad (BB) angeordnete Stäbe oder Rohre gebildet sind, die durch den Flüssigkeitdruck gegeneinander oder gegen das jeweils durchlaufende Werkstück (W) und gegen die zugeordnete Stirnwand der Behandlungszelle (BZ) gedrückt werden.

2. Vorrichtung nach Anspruch 1,
**dadurch gekennzeichnet,**
daß die Stäbe oder Rohre einen kreiszylindrischen Querschitt besitzen.

3. Vorrichtung nach Anspruch 1 oder 2,
**dadurch gekennzeichnet,**
daß die Dichtungen (D) in stirnseitig an den Behandlungszellen (BZ) angebrachten Schleusenkammern (SK) angeordnet sind.

4. Vorrichtung nach einem der vorhergehenden Ansprüuche,
**dadurch gekennzeichnet,**
daß die Dichtungen (D) aus Kunststoff bestehen.

5. Vorrichtung nach einem der vorhergehenden Ansprüuche,
**dadurch gekennzeichnet,**
daß die Dichtungen (D) in vertikaler Richtung aus Segmenten (SG) lose zusammengesetzt sind.

## Claims

1. Device for processing flat workpieces (W), in particular printed circuit boards, which are conveyed in the vertical position on a horizontal transport path through at least one processing cell (BZ) that contains a processing bath (BB), vertical slots (S) for the passage of the workpieces (W) being provided in the end walls of the processing cell (BZ), and seals (D) being assigned to the vertical slots (S), characterized in that the seals (D) are formed by bars or tubes which are arranged in pairs in the processing bath (BB) such that they are loose in the vertical direction and are pressed by the liquid pressure against one another or against the workpiece (W) respectively passing through and against the assigned end wall of the processing cell (BZ).

2. Device according to Claim 1, characterized in that the bars or tubes have a circular cylindrical cross section.

3. Device according to Claim 1 or 2, characterized in that the seals (D) are arranged in sluice chambers (SK) which are fitted at the ends to the processing cells (BZ).

4. Device according to one of the preceding claims, characterized in that the seals (D) consist of plastic.

5. Device according to one of the preceding claims, characterized in that the seals (D) are composed loosely of segments (SG) in the vertical direction.

## Revendications

1. Dispositif pour le traitement de pièces plates (P), en particulier de circuits imprimés, qui sont transportées en position verticale sur un chemin de transport horizontal à travers au moins une cellule de traitement (CT) contenant un bain de traitement (BT), des fentes verticales (F) pour le passage des pièces (P) étant prévues dans les parois frontales de la cellule de traitement (CT) et des joints d'étanchéité (J) étant attribués aux fentes verticales (F), caractérisé en ce que lesdits joints (J) sont formés de barreaux ou tubes disposés dans le bain de traitement par paire de façon mobile et selon une orientation verticale, lesdits barreaux ou tubes étant pressés par la pression du liquide l'un contre l'autre ou contre la pièce (P) entrain de passer selon le cas et contre la paroi frontale concernée de la cellule de traitement (CT).

2. Dispositif selon la revendication 1, caractérisé en ce que les barreaux ou tubes possèdent une section cylindrique circulaire.

3. Dispositif selon la revendication 1 ou 2, caractérisé en ce que les joints d'étanchéité (J) sont disposés dans des chambres de sas (CS) montées sur les côtés frontaux des cellules de traitement (CT).

4. Dispositif selon l'une des revendications précédentes, caractérisé en ce que les joints d'étanchéité (J) sont composés de matières synthétiques.

5. Dispositif selon l'une des revendications précédentes, caractérisé en ce que les joints d'étanchéité (J) sont constitués selon la direction verticale de segments agencés de manière détachable.
